# EUROPÄISCHE PATENTSCHRIFT

(11) **EP 0 719 455 B1**
(45) Veröffentlichungstag und Bekanntmachung des Hinweises auf die Patenterteilung: **23.06.1999**
(21) Anmeldenummer: 94926785.0
(22) Anmeldetag: 15.09.1994
(51) Int. Cl.: H01L 27/146, H01L 31/112, H01L 31/113

(54) **UNIPOLARTRANSISTOR MIT INTEGRIERTER RÜCKSETZSTRUKTUR**
SINGLE-POLE TRANSISTOR WITH INTEGRATED RESET STRUCTURE
TRANSISTOR UNIPOLAIRE A EFFET DE CHAMP COMPORTANT UNE STRUCTURE INTEGREE DE REMISE A L'ETAT INITIAL

(30) Priorität: 15.09.1993 DE 4331392
(43) Veröffentlichungstag der Anmeldung: 03.07.1996
(73) Patentinhaber: Max-Planck-Gesellschaft zur Förderung der Wissenschaften e.V., 80539 München (DE); KEMMER, Josef, Dr., D-85764 Oberschleissheim (DE)
(72) Erfinder: KEMMER, Josef, D-85764 Oberschleissheim (DE); LUTZ, Gerhard, D-81739 München (DE); RICHTER, Rainer, D-81243 München (DE)
(74) Vertreter: Münich, Wilhelm, Dr.
(86) Internationale Anmeldenummer: DE9401068
(87) Internationale Veröffentlichungsnummer: WO9508191

(56) Entgegenhaltungen:
- EP-A- 0 042 218
- EP-A- 0 111 346
- DE-A- 3 345 135
- DE-A- 3 345 190
- FR-A- 2 563 657
- GB-A- 1 444 541

## Beschreibung

### Technisches Gebiet

In der Patentanmeldung wird eine Rücksetzstruktur für einen Unipolartransistor, bestehend aus Source, Drain, Kanal, Top- und Backgate (bzw. internes Gate) vorgeschlagen.

### Stand der Technik

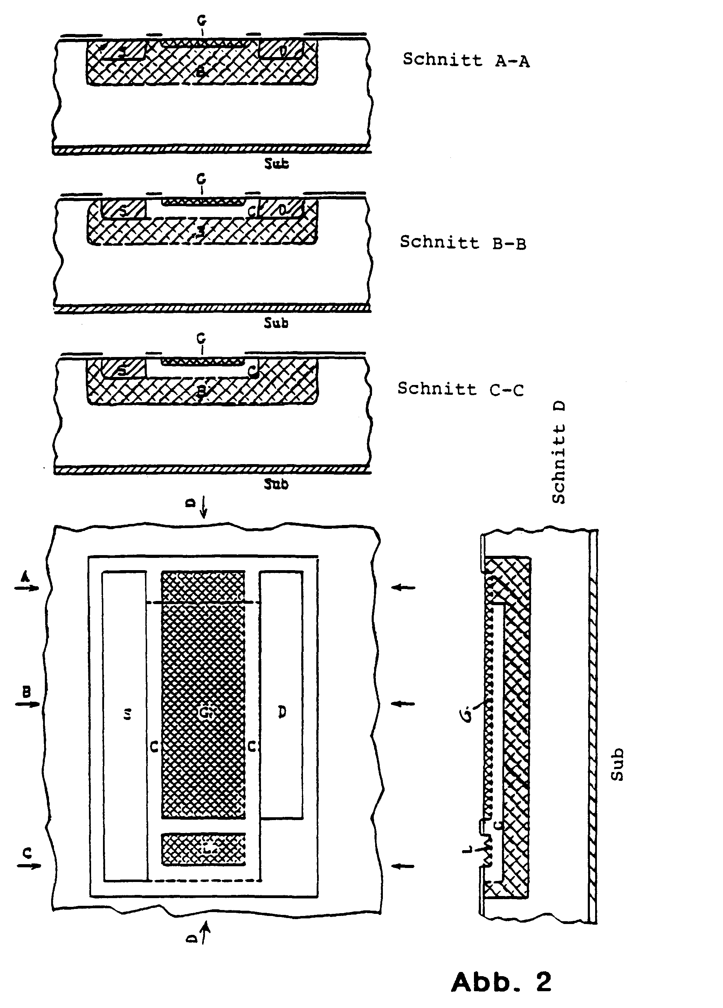

Wird dieser Unipolartransistor auf einem im wesentlichen verarmten Halbleiterkörper betrieben, erhält man eine Halbleiterstruktur, die sowohl Detektor- als auch Verstärkereigenschaften besitzt. Solche Halbleiterstrukturen sind beispielsweise aus DE 34 27 476.6 oder US 4 885 620 bekannt (s. ferner,, New Detector Concepts"; Nucl. Instr. & Meth. A 253, 365-377 (1987):,, EXPERIMENTAL CONFIRMATION OF A NEW SEMICONDUCTOR DETECTOR PRINCIPLE" sowie MPI-PAE/Exp-EL-204, Juni 1989; Nucl. Instr. & Meth. A 288 (1990), S. 92). Sie eignen sich als eigenständiger Detektor, als integrierte Auslesestruktur anderer Halbleiterdetektoren, wie z.B. Driftkammern (s.,, SEMICONDUCTOR DRIFT CHAMBERS FOR POSITION AND ENERGY MEASUREMENTS"; Nucl. Instrum. Methods A 235 (1985) S. 224-234.), Driftdioden (s. ,, Low Capacity Drift Diode"; Nucl. Instr. & Meth. A 253, S. 378-381 (1987) oder CCDs (s. ,,Device modeling of fully depletable CCDs"; Nucl. Instr. & Meth. A 253 (1987), S. 386-392 sowie ,,Development of Fully Depletable PN CCDs for High Energy Applications"; Nucl. Instr. & Meth. A 257 (1987) S. 594-602) und insbesondere als Grundelement von Bildzellen-Detektoren (s.,, Present and Future Semiconductor Tracking Detectors"; MPI-PAE / Exp.El. 175, April 1987 sowie,, New structures for position sensitive semiconductor detectors"; Nucl. Instr. & Meth. A 273 (1988), S. 588-598). DE 33 45 190 A1 beschreibt eine als Bildaufnahmewandler dienende Halbleiterstruktur, bei der in einen dotierten, durch Lichteinfall elektrisch aufgeladenes Signalspeicher-Gate-Bereich (4) ein Rücksetzbereich (13) eingebracht ist (s. Fig. 2).

In allen diesen Anwendungen bewirkt die in einem Potentialminimum (Maximum für negative Ladung) unterhalb des Transistorkanals gesammelte Ladung, dem "internen" Gate, eine Veränderung des Stromflusses des Unipolartransistors. Das Rücksetzen des Systems (Löschen der Signalladung) erfolgt entweder durch Anlegen eines Spannungspulses (positiv für gespeicherte Elektronen) an eine Lösch-Elektrode oder durch kontinuierliches Überlaufen des nahezu gefüllten Potentialtopfes.

Bei den bisher bekannten Rücksetzstrukturen ist die Rücksetzelektrode direkt benachbart zu den im wesentlichen verarmten, und als sensitive Detektorregion dienenden, Halbleiterkörper angebracht (positioniert). Dies hat den Nachteil, daß sich eine Spannungsänderung am Rücksetzkontakt unmittelbar auf die Potentialverteilung im Halbleiterkörper auswirkt und damit die Ladungssammlungseigenschaften der Halbleiterstruktur beeinflußt. Da das Potential der Löschelektrode zumindest während des Löschvorganges positiver als das Potential des internen Gates ist, kann zumindest ein Teil der Signalladung direkt zum Rücksetzkontakt abfließen, ohne daß sie zuvor im internen Gate gesammelt wird.

### Darstellung der Erfindung

Ziel der Erfindung ist es, diese Nachteile zu beseitigen und das Löschen der Detektor-Verstärkerstruktur ohne Beeinflussung der Ladungssammlungseigenschaften zu bewerkstelligen und insbesondere auch ein kontinuierliches Löschen der Signalladung zu ermöglichen, so daß die Detektor-Verstärkerstruktur totzeitfrei und auf gleichbleibendem Arbeitspunkt betrieben werden kann.

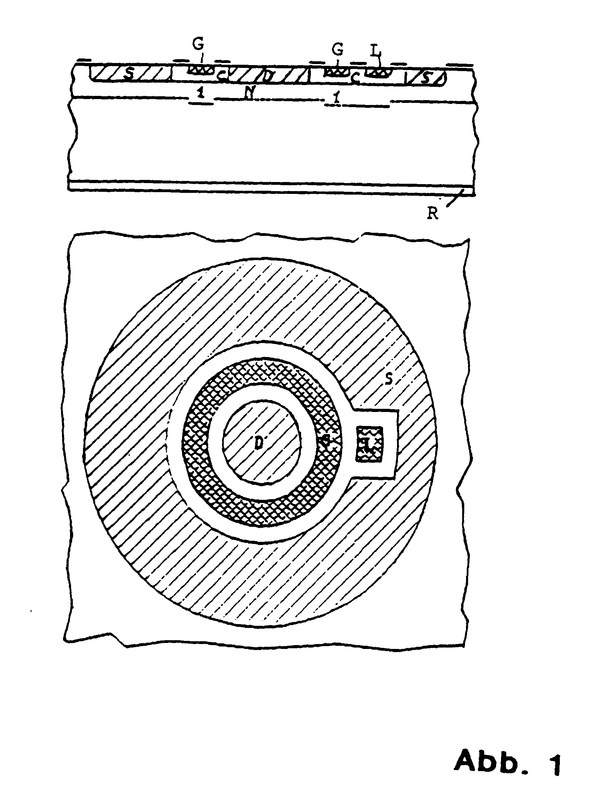

Diese Aufgabe wird erfindungsgemäß dadurch gelöst, daß der Löschkontakt (gleichen Leitungstyps wie das interne Gate) vom verarmten (sensitiven) Teil des Halbleiterkörpers durch mindestens ein potentialmäßig festgelegtes Gebiet unterschiedlichen Leitungstyps getrennt ist, und daß das Rücksetzen des internen Gates über dieses Gebiet hinweg erfolgt. Querschnitt und Aufsicht eines Ausführungsbeispiels ist in Abb. 1 gezeigt.

Hier ist der Unipolartransistor als ringförmiger p-Kanal Sperrschichtfeldeffekttransistor ausgeführt. Gate (G) und Source (S) sind deshalb an beiden Seiten der im Zentrum angeordneten Drain (D) zu sehen. Die Rücksetzelektrode befindet sich innerhalb des Kanalgebietes nahe der Source, an einer Stelle an der der Kanal verlängert ist. Er ist vom externen und internen Gate (1) durch die Kanalimplantation elektrisch isoliert. Betrachtet man nun die n-p-n Struktur des Systems von teilweise gefülltem und potentialmäßig schwimmendem internen Gate (1), Kanal (C) und Rücksetzelektrode (L), so wird bei zunehmend positiverem Potential der Rücksetzelektrode (L) ein Elektronenstrom vom internen Gate (1) über den Kanal hinweg zur Rücksetzelektrode (L) einsetzen, der somit das interne Gate (1) leert, und das Potential des internen Gates zu positiveren Werten hin verschiebt.

Das Einsetzen dieses Elektronenstromes erfolgt sehr langsam; es ergibt sich eine etwa exponentielle Strom-Spannungs-Charakteristik. Somit ist es möglich, das interne Gate (1) entweder durch Anlegen eines positiven Spannungspulses oder durch Anlegen eines konstanten Potentials an die Rücksetzelektrode zurückzusetzen. Es ist somit auch möglich, die Halbleiterstruktur totzeitfrei kontinuierlich zu betreiben.

Eine Erhöhung der Steuerwirkung auf den Transistorkanal und das gemeinsame Rücksetzen von internem und externem Gate können erreicht werden, wenn internes (1) und externes Gate (G) miteinander potentialmäßig verbunden werden. Dies kann z.B. durch Weglassen der Kanaldotierung (C) unter einem Teil (z.B. in der Nähe der Rücksetzelektrode) der (ringförmigen) Gatestruktur geschehen.

Die Möglichkeit des potentialmäßigen Rücksetzens des verbundenen Top- und Backgates ist auch in Anwendungen interessant, in denen der Halbleiterkörper nicht als Detektor verwendet wird und nur die Verstärkungseigenschaften der Struktur von Interesse sind.

Dies ist z.B. der Fall wenn die Struktur zum Auslesen eines externen, mit dem Gate (G) verbundenen Detektors verwendet wird. Es ist dann nicht nötig, den Halbleiterkörper zu verarmen. Dieser kann dann selbst als Backgate dienen, oder aber vom Backgate durch eine isolierende Schicht, z.B. eine in Sperrichtung vorgespannte Diode oder einen Isolator wie z.B. Si02 elektrisch isoliert sein.

Das Rücksetzen des Gates kann dabei in beide Richtungen, je nach Vorspannung der Rücksetzelektrode, durch Abziehen oder Einspeisung von Elektronen erfolgen.

### Kurze Beschreibung der Zeichnung

Ein Ausführungsbeispiel ist in Abb. 2 gezeigt. Hier wurde eine lineare Struktur gewählt. Der p-Kanal Sperrschichtfeldeffekttransistor befindet sich in einer ndotierten Wanne (B) auf einem p-Substrat. Die Wanne dient gleichzeitig als Backgate des Transistors. Source (S), Drain (D) und Kanal (C) sind p-dotiert. Das stark n-dotierte Gate (G) ist mit der als Backgate dienenden Wanne (B) durch Weglassen der Kanalimplantation in einem Teilbereich (Schnitt A) des Transistors verbunden. Im Bereich des Rücksetzkontaktes (L), in der eine Steuerwirkung auf den Kanal nur vom Backgate (B) erfolgt, ist die direkte Kanalverbindung von Source zu Drain unterbrochen (Schnitt C).

Eine vollständige Unterdrückung der direkten Steuerwirkung des Rücksetzkontakts auf den Transistorstrom könnte z.B. durch Wiederholung der in Schnitt A gezeigten Struktur am anderen Ende des Gates erreicht werden.

## Patentansprüche

1. Halbleiterstruktur mit einem Unipolartransistor, der eine Source (S), ein Drain (D), einen Kanalbereich (C), ein Topgate (G), eine potentialmäßig schwimmende Schicht (1), die ein internes Gate des Unipolartransistors darstellt, und einen Rücksetz- oder Löschkontakt (L) aufweist, **dadurch gekennzeichnet,** daß der Löschkontakt gleichen Leitungstyps wie die potentialmäßig schwimmende Schicht ist und von ihr durch einen Bereich unterschiedlichen Leitungstyps, aber festgelegten Potentials getrennt ist.

2. Halbleiterstruktur nach Anspruch 1,
**dadurch gekennzeichnet**, daß der Unipolartransistor ein MOS Verarmungs- oder Anreicherungstransistor ist.

3. Halbleiterstruktur nach Anspruch 1,
**dadurch gekennzeichnet**, daß der Unipolartransistor ein Sperrschichtfeldeffekttransistor ist.

4. Halbleiterstruktur nach einem der Ansprüche 1 bis 3, **dadurch gekennzeichnet**, daß der Bereich festgelegten Potentials der Kanalbereich (C) des Unipolartransistors ist.

5. Halbleiterstruktur nach einem der Ansprüche 1 bis 4, **dadurch gekennzeichnet**, daß sich der Löschkontakt im Bereich zwischen Source und Gate oder Drain befindet.

6. Halbleiterstruktur nach Anspruch 5, **dadurch gekennzeichnet**, daß der Kanal Source und Drain nur außerhalb einer Umgebung des Rücksetzkontaktes miteinander verbindet.

7. Halbleiterstruktur nach einem der Ansprüche 1 bis 6, **dadurch gekennzeichnet,** daß die potentialmäßig schwimmende Schicht, d.h. das interne Gate, und das Topgate miteinander potentialmäßig verbunden sind.

8. Halbleiterstruktur nach Anspruch 7, **dadurch gekennzeichnet,** daß das Topgate und das interne Gate über einen undotierten Teilbereich des Kanals miteinander verbunden sind.

9. Halbleiterstruktur nach einem der Ansprüche 1 bis 8,
dadurch **gekennzeichnet**, daß
der Halbleiterkörper unterhalb der potentialmäßig schwimmenden Schicht, d.h. des internen Gates, im wesentlichen verarmt ist.

## Claims

1. Semiconductor structure comprising a single-pole transistor including a source (S), a drain (D), a channel region (C), a top gate (G), a layer (1) floating in terms of potential, which constitutes an internal gate of said single-pole transistor, and a reset or zeroing contact (L), **characterised** in that said zeroing contact is of the same conductivity type as said layer floating in terms of potential, and is separated therefrom by a region of a different conductivity type even though of a defined potential.

2. Semiconductor structure according to Claim 1,
**characterised** in that said single-pole transistor is a MOS-type transistor of the depletion or enhancement type.

3. Semiconductor structure according to Claim 1,
**characterised** in that said single-pole transistor is a depletion layer field effect transistor.

4. Semiconductor structure according to any of the Claims 1 to 3,
**characterised** in that said region of defined potential is the channel region (C) of said single-pole transistor.

5. Semiconductor structure according to any of the Claims 1 to 4,
**characterised** in that said zeroing contact is located in the region between said source and said gate or said drain.

6. Semiconductor structure according to Claim 5,
**characterised** in that said channel interconnects said source and said drain only beyond a vicinity of said zeroing contact.

7. Semiconductor structure according to any of the Claims 1 to 6,
**characterised** in that said layer floating in terms of potential, i.e. said internal gate, and said top gate are connected to each other in terms of potential.

8. Semiconductor structure according to Claim 7,
**characterised** in that said top gate and said internal gate are connected to each other via a non-doped sub-region of said channel.

9. Semiconductor structure according to any of the Claims 1 to 8,
characterised in that the semiconductor body is substantially depleted underneath said layer floating in terms of potential, i.e. said internal gate.

## Revendications

1. Structure semi-conductrice munie d'un transistor unipolaire comprenant une source (S), un drain (D), une zone de canal (C), une gâchette supérieure (G), une couche (1) à potentiel fluctuant, formant une gâchette intérieure du transistor unipolaire, et un contact (L) de remise à l'état initial ou d'effacement, caractérisée par le fait que le contact d'effacement est d'un même type de conducteur que la couche à potentiel fluctuant, et est séparé de cette dernière par une zone d'un type de conducteur différent, mais à potentiel fermement établi.

2. Structure semi-conductrice selon la revendication 1,
caractérisée par le fait que le transistor unipolaire est un transistor M.O.S. à déplétion ou d'enrichissement.

3. Structure semi-conductrice selon la revendication 1,
caractérisée par le fait que le transistor unipolaire est un transistor à effet de champ à grille isolée.

4. Structure semi-conductrice selon l'une des revendications 1 à 3, caractérisée par le fait que la zone à potentiel fermement établi est la zone de canal (C) du transistor unipolaire.

5. Structure semi-conductrice selon l'une des revendications 1 à 4, caractérisée par le fait que le contact d'effacement se trouve dans la zone située entre la source et la gâchette ou le drain.

6. Structure semi-conductrice selon la revendication 5, caractérisée par le fait que le canal relie, l'un à l'autre, la source et le drain uniquement à l'extérieur d'un environnement du contact de remise à l'état initial.

7. Structure semi-conductrice selon l'une des revendications 1 à 6,
caractérisée par le fait que la gâchette supérieure et la couche à potentiel fluctuant, c'est-à-dire la gâchette intérieure, sont en liaison mutuelle par potentiel.

8. Structure semi-conductrice selon la revendication 7, caractérisée par le fait que la gâchette supérieure et la gâchette intérieure sont reliées l'une à l'autre par l'intermédiaire d'une zone partielle non dopée du canal.

9. Structure semi-conductrice selon l'une des revendications 1 à 8,
caractérisée par le fait que
le corps semi-conducteur situé au-dessous de la couche à potentiel fluctuant, c'est-à-dire de la gâchette intérieure, est pour l'essentiel appauvri.
